# EUROPEAN PATENT SPECIFICATION

(11) **EP 4 285 419 B1**
(45) Date of publication and mention of the grant of the patent: **14.10.2026**
(21) Application number: 22702608.5
(22) Date of filing: 14.01.2022
(51) Int. Cl.: H10N 50/80, H10N 50/10, H10N 50/01

(54) **MRAM CONTAINING MAGNETIC TOP CONTACT**
MRAM MIT MAGNETISCHEM OBERKONTAKT
MRAM CONTENANT UN CONTACT SUPÉRIEUR MAGNÉTIQUE

(30) Priority: 27.01.2021 US 202117248479
(43) Date of publication of application: 06.12.2023
(73) Proprietor: International Business Machines Corporation, Armonk, New York 10504 (US)
(72) Inventor: RIZZOLO, Michael, Albany, New York 12203-3654 (US); ZARE, Saba, Yorktown Heights, New York 10598-0218 (US); MEHTA, Virat, Vasav, Albany, New York 12203-3654 (US); EVARTS, Eric, Raymond, Albany, New York 12203-3654 (US)
(74) Representative: IBM United Kingdom Limited
(86) International application number: PCT/EP2022/050731
(87) International publication number: WO 2022/161792

(56) References cited:
- US-A1- 2009 237 982
- US-A1- 2012 205 764
- US-A1- 2017 098 759

## Description

### Technical Field

The present invention relates to memory devices, and more specifically, to magnetic random-access memory (MRAM).

### BACKGROUND

Unlike conventional random-access memory (RAM) chip technologies, magnetic RAM (MRAM) does not store data as electric charge, but instead stores data by magnetic polarization of storage elements. Typically, storage elements are formed from two ferromagnetic layers separated by a tunneling layer. One of the ferromagnetic layers has at least one pinned magnetic polarization (also known as a 'reference' or 'fixed' layer) set to a particular polarity. The magnetic polarity of the other ferromagnetic layer (or free layer) is altered to represent either a "1" (i.e., anti-parallel polarity to the fixed layer) or "0" (i.e., parallel polarity to the fixed layer). One device having a fixed layer, a tunneling layer, and a free layer is a magnetic tunnel junction (MTJ). The electrical resistance of a MTJ is dependent on the magnetic polarity of the free layer compared to the magnetic polarity of the fixed layer. A memory device such as MRAM can be built from an array of individually addressable MTJs.

In Magnetic Tunnel Junctions (MTJs) the current induced magnetization is the main phenomenon of interest for MRAM devices. So, the average external magnetic field on the Free Layer (FL) needs to be zero. In order to do that the reference layer is separated with a thin Antiferromagnetic layer to have opposite magnetization and the zero magnetic field is achieved by balancing these two layers. The balancing between the two layers can be very challenging and is being carried out by controlling down to a few angstroms of thickness in each of those layers. Further, some integration process flows, such as IBE can simply modify the size of reference layers and change the balance even after the blanket film deposition by non-uniformly etching the top and bottom reference layer in their sidewalls.

Therefore, there is a need in the art to address the aforementioned problem. US20120205764A1 describes a method and apparatus for shielding a non-volatile memory, such as shielding a magnetic tunnel junction (MTJ) device from a magnetic flux. US20170098759A1 describes a semiconductor device including a magnetic tunnel junction structure on a lower electrode, an intermediate electrode on the magnetic tunnel junction structure, and an upper electrode on the intermediate electrode, wherein the intermediate electrode includes a lower portion and an upper portion having a side surface profile different from that of the lower portion. US20090237982A1 describes techniques for shielding magnetic memory cells from magnetic fields. In accordance with aspects of the invention, a magnetic storage element is formed with at least one conductive segment electrically coupled to the magnetic storage element.

### BRIEF SUMMARY

The present invention provides a magnetic random-access memory (MRAM) structure and a method of forming a magnetic random-access memory (MRAM) structure as set forth in the appended claims.

Aspects of the invention may enable the magnetic liner to act as an independent variable to balance many of the magnetic parameters in the MTJ film stack in order to achieve zero magnetic field at the MTJ layer.

The ferromagnetic material may be cobalt.

The ferromagnetic material may be nickel, iron, rare-earth elements, or combinations thereof.

A thickness of the ferromagnetic material may be 1 to 20 nm.

There may be a diffusion liner between the top contact and the magnetic liner. This may improve long term device reliability and function of the magnetic liner.

### BRIEF DESCRIPTION OF THE DRAWINGS

The present invention will now be described, by way of example only, with reference to preferred embodiments, as illustrated in the following figures:
FIG. 1 depicts an MRAM cell, outside the scope of the present invention, in an initial fabrication stage;
FIG. 2 depicts an MRAM cell following deposition of an inverted cup-shaped magnetic liner on a metal hardmask;
FIG. 3 depicts an MRAM cell following deposition of a liner;
FIG. 4 depicts an MRAM cell following formation of a top contact;
FIG. 5 depicts an MRAM cell, according to an exemplary embodiment of the present invention, in an initial fabrication stage;
FIG. 6 depicts an MRAM cell following deposition of a magnetic liner on a metal hardmask, according to the exemplary embodiment;
FIG. 7 depicts an MRAM cell following deposition of a primarily flat liner, according to the exemplary embodiment;
FIG. 8 depicts an MRAM cell following formation of a top contact, according to the exemplary embodiment;
FIG. 9 depicts an MRAM cell, according to a second exemplary embodiment of the present invention, in an initial fabrication stage;
FIG. 10 depicts an MRAM cell following deposition of a ringed magnetic liner around a metal hardmask, according to the second exemplary embodiment;
FIG. 11 depicts an MRAM cell following deposition of a liner, according to the second exemplary embodiment; and
FIG. 12 depicts an MRAM cell following formation of a top contact, according to the second exemplary embodiment.

Elements of the figures are not necessarily to scale and are not intended to portray specific parameters of the invention. For clarity and ease of illustration, dimensions of elements may be exaggerated. The detailed description should be consulted for accurate dimensions. The drawings are intended to depict only typical embodiments of the invention, and therefore should not be considered as limiting the scope of the invention. In the drawings, like numbering represents like elements.

### DETAILED DESCRIPTION

Exemplary embodiments now will be described more fully herein with reference to the accompanying drawings, in which exemplary embodiments are shown. This disclosure may, however, be embodied in many different forms and should not be construed as limited to the exemplary embodiments set forth herein. Rather, these exemplary embodiments are provided so that this disclosure will be thorough and complete and will convey the scope of this disclosure to those skilled in the art. In the description, details of well-known features and techniques may be omitted to avoid unnecessarily obscuring the presented embodiments.

For purposes of the description hereinafter, terms such as "upper", "lower", "right", "left", "vertical", "horizontal", "top", "bottom", and derivatives thereof shall relate to the disclosed structures and methods, as oriented in the drawing figures. Terms such as "above", "overlying", "atop", "on top", "positioned on" or "positioned atop" mean that a first element, such as a first structure, is present on a second element, such as a second structure, wherein intervening elements, such as an interface structure may be present between the first element and the second element. The term "direct contact" means that a first element, such as a first structure, and a second element, such as a second structure, are connected without any intermediary conducting, insulating or semiconductor layers at the interface of the two elements.

In the interest of not obscuring the presentation of embodiments of the present invention, in the following detailed description, some processing steps or operations that are known in the art may have been combined together for presentation and for illustration purposes and in some instances may have not been described in detail. In other instances, some processing steps or operations that are known in the art may not be described at all. It should be understood that the following description is rather focused on the distinctive features or elements of various embodiments of the present invention.

By adding a selective metal liner to a contact of the MTJ stack, we can create an additional tunable parameter to balance the magnetic field on the free layer.

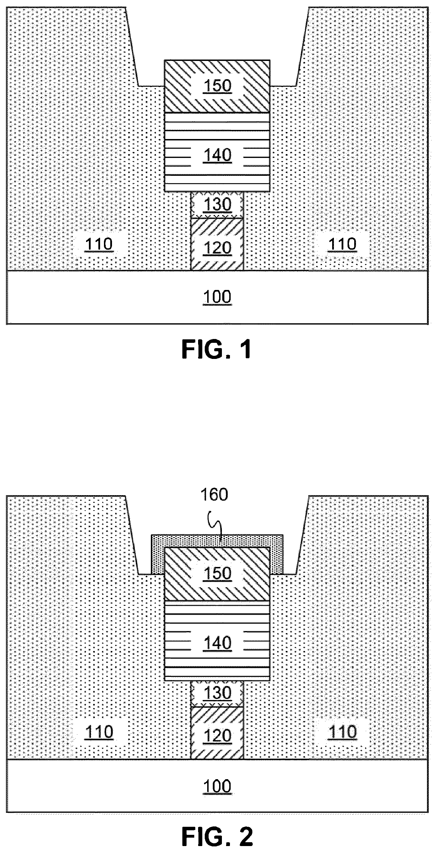

FIG. 1 depicts a starting magnetic random access memory (MRAM), outside the scope of the present invention. The MRAM device is located on an Mx layer 100 of a semiconductor device. The MRAM device may include a bottom contact 120, a diffusion barrier 130, a magnetic tunnel junction (MTJ) stacks 140, and a metal hardmask 150. The MRAM device may be isolated from surrounding devices by an ILD 110.

The Mx layer 100 may include underlying wiring, memory, or logic devices. Such underlying structure use the state contained in the MRAM in calculations or functioning of the semiconductor device that the MRAM is a part of.

The ILD 110 may be selected from the group consisting of silicon containing materials such as SiO2, Si3N4, SiOxNy, SiC, SiCO, SiCOH, and SiCH compounds, the above-mentioned silicon containing materials with some or all of the Si replaced by carbon doped oxides, inorganic oxides, inorganic polymers, hybrid polymers, organic polymers such as polyamides or SiLK^{™}, other carbon containing materials, organo-inorganic materials such as spin-on glasses and silsesquioxane-based materials, and diamond-like carbon (DLC), also known as amorphous hydrogenated carbon, α-C:H). Additional choices for the ILD 110 include any of the aforementioned materials in porous form, or in a form that changes during processing to or from being porous and/or permeable to being non-porous and/or non-permeable. In the current embodiment, the trench in the ILD 110 goes beneath the top of the metal hardmask 150, which enables a metal liner 160 to be formed down the sides of the metal hardmask 150. The distance of the trench down the height of the metal hardmask 150 may be 5-50% of the height of the metal hardmask 150.

Bottom contact 120 may include a connection to other devices located throughout a semiconductor device. Bottom contact 120 may include materials such as, for example, copper, aluminum, titanium nitride, tantalum nitride or tungsten.

Diffusion barrier 130 may be any conductive material that blocks migration of atoms or ions out of the MTJ stack 140 into the bottom contact 120 or vice versa. For example, the diffusion barrier 130 may be formed of a metal such as tantalum, titanium, tungsten, tungsten nitride, nickel, platinum, ruthenium, or the like.

The MTJ stack 140 includes two layers of ferromagnetic material separated by a thin insulating tunnel barrier layer. The insulating tunnel barrier layer is sufficiently thin that quantum-mechanical tunneling of the charge carriers occurs between the ferromagnetic electrodes. The tunneling process is electron spin dependent, which means that the tunneling current across the junction depends on the spin-dependent electronic properties of the ferromagnetic materials and is a function of the relative orientation of the magnetic moments (magnetization directions) of the two ferromagnetic layers. The two ferromagnetic layers are designed to have different responses to magnetic fields so that the relative orientation of their moments can be varied with an external magnetic field. The MTJ is usable as, e.g., a memory cell in a nonvolatile magnetic random access memory (MRAM) array, and as, e.g., a magnetic field sensor, such as a magnetoresistive read head in a magnetic recording disk drive. The ferromagnetic layer material can be any suitable material, combination of materials, or alloy that exhibits magnetic properties, such as a ferromagnetic material or a ferromagnetic thin film including CoFe, CoFeB, NiFe, etc. The insulating layer may be any suitable material, or combination of materials that may be insulating and allow tunneling across the insulating layer.

MRAM is a type of solid state memory that uses tunneling magnetoresistance (TMR) to store information. MRAM is made up of an electrically connected array of magnetoresistive memory elements, referred to as magnetic tunnel junctions (MTJs). Each MTJ includes a free layer having a magnetization direction that is variable, and a fixed layer having a magnetization direction that is invariable. The free layer and fixed layer each include a layer of a magnetic material and are separated by an insulating non-magnetic tunnel barrier. An MTJ stores information by switching the magnetization state of the free layer. When the magnetization direction of the free layer is parallel to the magnetization direction of the fixed layer, the MTJ is in a low resistance state. When the magnetization direction of the free layer is antiparallel to the magnetization direction of the fixed layer, the MTJ is in a high resistance state. The difference in resistance of the MTJ can be used to indicate a logical '1' or '0', thereby storing a bit of information. The TMR of an MTJ determines the difference in resistance between the high and low resistance states. A relatively high difference between the high and low resistance states facilitates read operations in the MRAM.

The metal hardmask 150 may be a metal layer used to define the footprint of the MTJ stack 140 during formation. The metal hardmask 150 can be tantalum nitride, titanium nitride, tungsten nitride, ruthenium/ruthenium nitride, cobalt nitride, platinum-group metal nitrides, their pure-metal counterparts, or the like.

Referring to FIG. 2, a magnetic liner 160 is selectively deposited on the surfaces of the metal hardmask 150. Deposition of the magnetic liner 160 may be performed by atomic layer deposition (ALD), chemical vapor deposition (CVD), or any other suitable techniques that may selectively deposit the magnetic liner 160 on metal hardmask 150 without depositing the magnetic liner on the ILD 110. The magnetic liner 160 may be a ferromagnetic liner capable of exerting a magnetic field on MTJ stack 140. The magnetic liner 160 may be made of materials such as, for example, cobalt, nickel, iron, rare-earth elements, or a combination thereof. The magnetic liner may have a thickness of approximately 1 to 20 nm and may extend 5-50 % of the height of the metal hardmask 150.

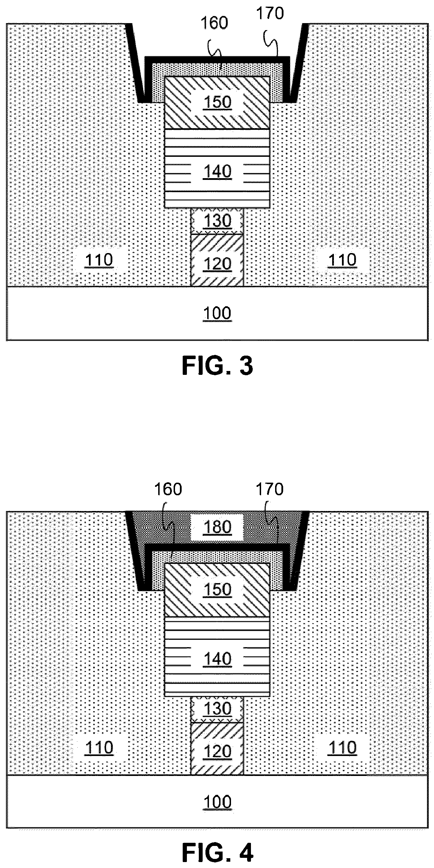

Referring to FIG. 3, a liner 170 may be deposited on the magnetic liner, and along the sidewalls of the trench. Similar to the diffusion barrier 130, the liner 170 may include materials capable of blocking migration of atoms or ions out of or into the magnetic liner 160. The liner may be made of, for example, tantalum or tantalum nitride, and may include one or more layers of liner material. The liner 170 may be formed using a filling deposition technique such as electroplating, electroless plating, chemical vapor deposition, physical vapor deposition or a combination of methods.

Referring to FIG. 4, the trench may be filled with a top contact 180. Top contact 180 may be selected as a low resistance metal such as, for example, Al, W, Cu, TiN, TaN, or other suitable materials. The top contact 180 may be formed using a filling technique such as electroplating, electroless plating, chemical vapor deposition, physical vapor deposition or a combination of methods. The top contact 180 may be formed as part of a trench or via and may be connected to additional wiring on higher levels of the semiconductor chip.

Following the steps outlined in FIGS. 1-4, an MRAM cell exists having a magnetic liner 160 separated from an MTJ stack 140 by a metal hardmask 150. The MTJ stack 140 may be separated from a bottom contact 120 by a diffusion barrier 130. The magnetic liner 160 may be separated from the top contact 180 by a liner 170. The magnetic liner 160 may be located on all portions of the metal hardmask 160 that extends past ILD 110. This may enable the magnetic liner 160 to balance the magnetic field on the free layer of the MTJ stack 140 in order to achieve a 0 magnetic field at that layer. This may enable the magnetic liner to act as an independent variable to balance many of the magnetic parameters in the MTJ film stack.

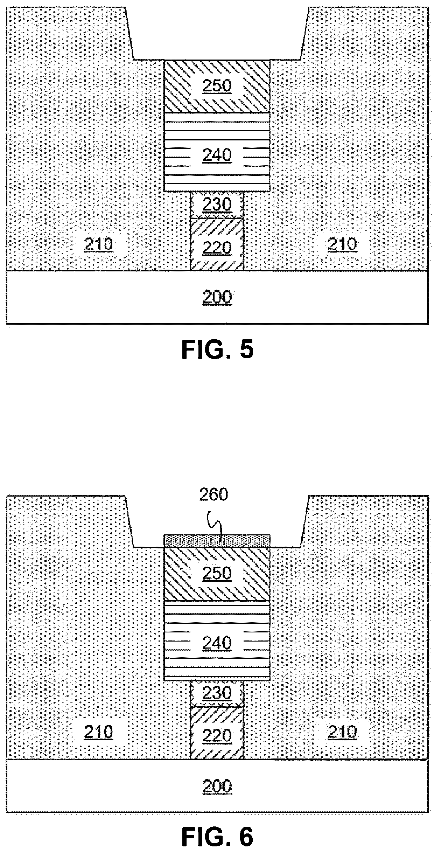

FIG. 5 depicts a starting magnetic random access memory (MRAM), according to an embodiment of the present invention. The MRAM device is located on an Mx layer 200 of a semiconductor device. The MRAM device may include a bottom contact 220, a diffusion barrier 230, and includes a magnetic tunnel junction (MTJ) stack 240 and a metal hardmask 250. The MRAM device may be isolated from surrounding devices by an ILD 210.

The Mx layer 200 may include underlying wiring, memory, or logic devices. Such underlying structure use the state contained in the MRAM in calculations or functioning of the semiconductor device that the MRAM is a part of.

The ILD 210 may be selected from the group consisting of silicon containing materials such as SiO2, Si3N4, SiOxNy, SiC, SiCO, SiCOH, and SiCH compounds, the above-mentioned silicon containing materials with some or all of the Si replaced by carbon doped oxides, inorganic oxides, inorganic polymers, hybrid polymers, organic polymers such as polyamides or SiLK^{™}, other carbon containing materials, organo-inorganic materials such as spin-on glasses and silsesquioxane-based materials, and diamond-like carbon (DLC), also known as amorphous hydrogenated carbon, α-C:H). Additional choices for the ILD 210 include any of the aforementioned materials in porous form, or in a form that changes during processing to or from being porous and/or permeable to being non-porous and/or non-permeable. The bottom of the trench formed in the ILD 110 is substantially coplanar to the top surface of the metal hardmask 250.

Bottom contact 220 may include a connection to other devices located throughout a semiconductor device. Bottom contact 220 may include materials such as, for example, copper, aluminum, titanium nitride, tantalum nitride or tungsten.

Diffusion barrier 230 may be any conductive material that blocks migration of atoms or ions out of the MTJ stack 240 into the bottom contact 220 or vice versa. For example, the diffusion barrier 230 may be formed of a metal such as tantalum, titanium, tungsten, tungsten nitride, nickel, platinum, ruthenium, or the like.

The MTJ stack 240 is as described relative to the MTJ stack 140.

[Reserved]

The metal hardmask 250 is a metal layer used to define the footprint of the MTJ stack 240 during formation. The metal hardmask 250 can be tantalum nitride, titanium nitride, tungsten nitride, ruthenium/ruthenium nitride, cobalt nitride, platinum-group metal nitrides, their pure-metal counterparts, or the like.

Referring to FIG. 6, a magnetic liner 260 is selectively deposited on the surfaces of the metal hardmask 250. Deposition of the magnetic liner 260 may be performed by atomic layer deposition (ALD), chemical vapor deposition (CVD), or any other suitable techniques that may selectively deposit the magnetic liner 260 on metal hardmask 250 without depositing the magnetic liner on the ILD 210. The magnetic liner 260 may be a ferromagnetic liner capable of exerting a magnetic field on MTJ stack 240. The magnetic liner 260 may be made of materials such as, for example, cobalt, nickel, iron, rare-earth elements, or a combination thereof. The magnetic liner may have a thickness of approximately 2 to 20 nm and may extend 5-50 % of the height of the metal hardmask 250.

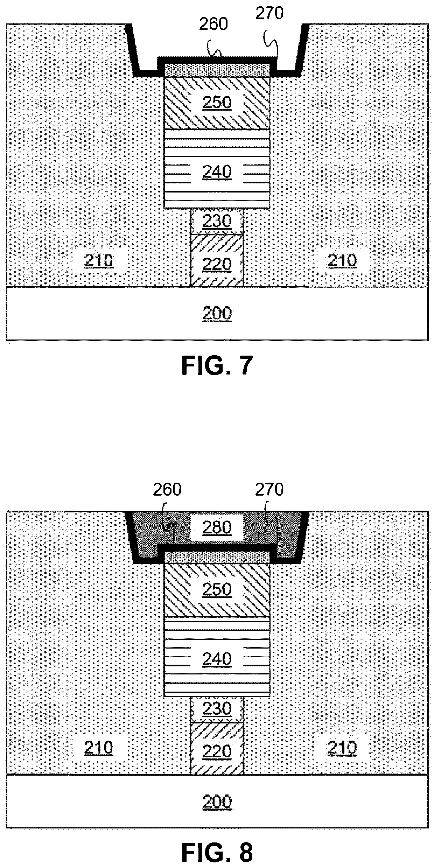

Referring to FIG. 7, a liner 270 may be deposited on the magnetic liner, and along the sidewalls of the trench. Similar to the diffusion barrier 230, the liner 270 may include materials capable of blocking migration of atoms or ions out the magnetic liner 260. The liner may be made of, for example, tantalum or tantalum nitride, and may include one or more layers of liner material. The liner 270 may be formed using a filling technique such as electroplating, electroless plating, chemical vapor deposition, physical vapor deposition or a combination of methods.

Referring to FIG. 8, the trench is filled with a top contact 280. Top contact 280 may be selected as a low resistance metal such as, for example, Al, W, Cu, TiN, TaN, or other suitable materials. The top contact 280 may be formed using a filling technique such as electroplating, electroless plating, chemical vapor deposition, physical vapor deposition or a combination of methods. The top contact 280 may be formed as part of a trench or via and may be connected to additional wiring on higher levels of the semiconductor chip.

Following the steps outlined in FIGS. 5-8, an MRAM cell exists having a magnetic liner 260 separated from an MTJ stack 240 by a metal hardmask 250. The MTJ stack 240 may be separated from a bottom contact 220 by a diffusion barrier 230. The magnetic liner 260 may be separated from the top contact 280 by a liner 270. The magnetic liner 260 is located only on the top surface of the metal hardmask 260. This may enable the magnetic liner 260 to balance the magnetic field on the free layer of the MTJ stack 240 in order to achieve a 0 magnetic field at that layer. This may enable the magnetic liner to act as an independent variable to balance many of the magnetic parameters in the MTJ film stack.

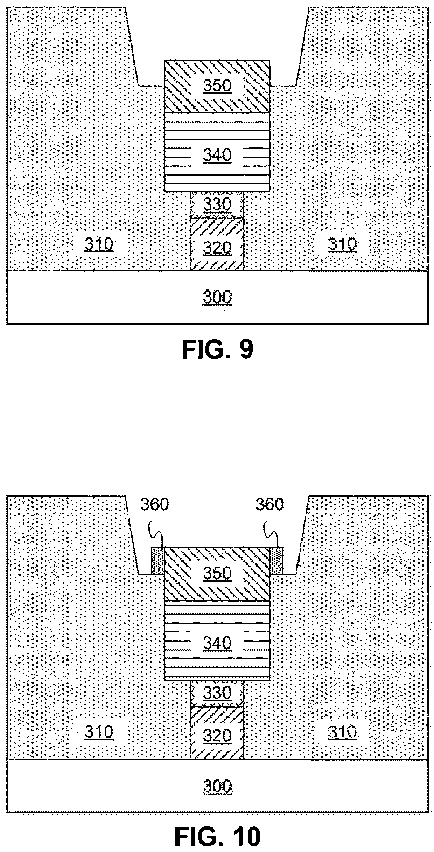

FIG. 9 depicts a starting magnetic random access memory (MRAM), according to a second embodiment of the present invention. The MRAM device is located on an Mx layer 300 of a semiconductor device. The MRAM device may include a bottom contact 320, a diffusion barrier 330, and includes a magnetic tunnel junction (MTJ) stack 340 and a metal hardmask 350. The MRAM device may be isolated from surrounding devices by an ILD 310.

The Mx layer 300 may include underlying wiring, memory, or logic devices. Such underlying structure use the state contained in the MRAM in calculations or functioning of the semiconductor device that the MRAM is a part of.

The ILD 310 may be selected from the group consisting of silicon containing materials such as SiO2, Si3N4, SiOxNy, SiC, SiCO, SiCOH, and SiCH compounds, the above-mentioned silicon containing materials with some or all of the Si replaced by carbon doped oxides, inorganic oxides, inorganic polymers, hybrid polymers, organic polymers such as polyamides or SiLK^{™}, other carbon containing materials, organo-inorganic materials such as spin-on glasses and silsesquioxane-based materials, and diamond-like carbon (DLC), also known as amorphous hydrogenated carbon, α-C:H). Additional choices for the ILD 310 include any of the aforementioned materials in porous form, or in a form that changes during processing to or from being porous and/or permeable to being non-porous and/or non-permeable. In the current embodiment, the trench in the ILD 110 goes beneath the top of the metal hardmask 150, which enables a metal liner 160 to be formed down the sides of the metal hardmask 150. The distance of the trench down the height of the metal hardmask 150 may be 5-50% of the height of the metal hardmask 150

Bottom contact 320 may include a connection to other devices located throughout a semiconductor device. Bottom contact 320 may include materials such as, for example, copper, aluminum, titanium nitride, tantalum nitride or tungsten.

Diffusion barrier 330 may be any conductive material that blocks migration of atoms or ions out of the MTJ stack 340 into the bottom contact 320 or vice versa. For example, the diffusion barrier 330 may be formed of a metal such as tantalum, titanium, tungsten, tungsten nitride, nickel, platinum, ruthenium, or the like.

The MTJ stack 340 is as described relative to the MTJ stack 140.

[Reserved]

The metal hardmask 350 is a metal layer used to define the footprint of the MTJ stack 340 during formation. The metal hardmask 350 can be tantalum nitride, titanium nitride, tungsten nitride, ruthenium/ruthenium nitride, cobalt nitride, platinum-group metal nitrides, their pure-metal counterparts, or the like.

Referring to FIG. 10, a magnetic liner 360 is selectively deposited on the surfaces of the metal hardmask 350. Deposition of the magnetic liner 360 may be performed by atomic layer deposition (ALD), chemical vapor deposition (CVD), or any other suitable techniques that may selectively deposit the magnetic liner 360 on metal hardmask 350 without depositing the magnetic liner on the ILD 310. The magnetic liner 360 may be a ferromagnetic liner capable of exerting a magnetic field on MTJ stack 340. The magnetic liner 360 may be made of materials such as, for example, Cobalt, nickel, iron, rare-earth elements, or a combination thereof. The magnetic liner may have a thickness of approximately 3 to 30 nm and may extend 5-50 % of the height of the metal hardmask 350. Following selective deposition, an anisotropic etch, such as RIE, may be performed to remove the magnetic material from the top surface of the metal hardmask 250.

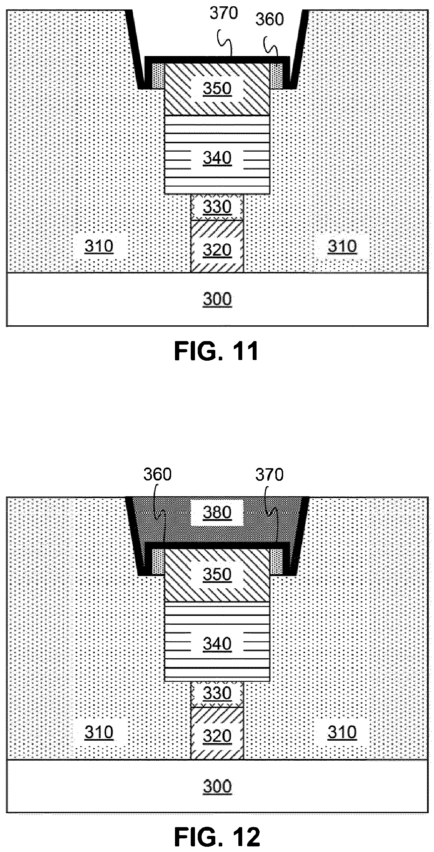

Referring to FIG. 11, a liner 370 may be deposited on the magnetic liner, and along the sidewalls of the trench. Similar to the diffusion barrier 330, the liner 370 may include materials capable of blocking migration of atoms or ions out the magnetic liner 360. The liner may be made of, for example, tantalum or tantalum nitride, and may include one or more layers of liner material. The liner 370 may be formed using a filling technique such as electroplating, electroless plating, chemical vapor deposition, physical vapor deposition or a combination of methods.

Referring to FIG. 12, the trench is filled with a top contact 380. Top contact 380 may be selected as a low resistance metal such as, for example, Al, W, Cu, TiN, TaN, or other suitable materials. The top contact 380 may be formed using a filling technique such as electroplating, electroless plating, chemical vapor deposition, physical vapor deposition or a combination of methods. The top contact 380 may be formed as part of a trench or via, and may be connected to additional wiring on higher levels of the semiconductor chip.

Following the steps outlined in FIGS. 9-12, an MRAM cell exists having a magnetic liner 360 separated from an MTJ stack 340 by a metal hardmask 350. The MTJ stack 340 may be separated from a bottom contact 320 by a diffusion barrier 330. The magnetic liner 360 may be separated from the top contact 380 by a liner 370. The magnetic liner 360 is located only on portions of the sidewall of the metal hardmask 360 and may extend past ILD 310. This may enable the magnetic liner 360 to balance the magnetic field on the free layer of the MTJ stack 340 in order to achieve a 0 magnetic field at that layer. This may enable the magnetic liner to act as an independent variable to balance many of the magnetic parameters in the MTJ film stack.

The descriptions of the various embodiments of the present invention have been presented for purposes of illustration but are not intended to be exhaustive or limited to the embodiments disclosed. Many modifications and variations will be apparent to those of ordinary skill in the art without departing from the scope of the described embodiments. The terminology used herein was chosen to best explain the principles of the embodiment, the practical application or technical improvement over technologies found in the marketplace, or to enable other of ordinary skill in the art to understand the embodiments disclosed herein. It is therefore intended that the present invention not be limited to the exact forms and details described and illustrated but fall within the scope of the appended claims.

## Claims

1. A magnetic random-access memory, MRAM, structure comprising:
a magnetic tunnel junction stack (240, 340);
a magnetic liner (260, 360) located between the magnetic tunnel junction stack and a top contact (280, 380), wherein the magnetic liner comprises a ferromagnetic material; and
a metal (250, 350) located between the magnetic liner and the magnetic tunnel junction stack;
**characterized in that** the magnetic liner is located only on one of a top surface of the metal and a side surface of the metal.

2. The MRAM structure of claim 1, wherein the ferromagnetic material comprises at least one material selected from the group consisting of: cobalt, nickel, iron, rare-earth elements.

3. The MRAM structure of either of the preceding claims, wherein a thickness of the ferromagnetic material is 1 nm to 20 nm.

4. The MRAM structure of any of the preceding claims, further comprising a diffusion liner (270, 370) between the top contact and the magnetic liner.

5. The MRAM structure of claim 1, wherein the magnetic liner is located on a side surface of the metal

6. A method of forming a magnetic random-access memory, MRAM, structure comprising:
forming a magnetic tunnel junction stack (240, 340);
forming a magnetic liner (260, 360) above the magnetic tunnel junction stack; and
forming a top contact (280, 380) above the magnetic liner, wherein the magnetic liner comprises a ferromagnetic material; and, forming a metal hardmask (250, 350) between the magnetic liner and the magnetic tunnel junction stack; **characterized in that** the method comprises:
forming the magnetic liner only on one of a top surface and a side surface of the metal hardmask.

7. The method of claim 6, wherein the ferromagnetic material comprises at least one material selected from the group consisting of: cobalt, nickel, iron, rare-earth elements.

8. The method of claim 6, further comprising:
forming the magnetic liner on a side surface of the metal hardmask.

9. The method of any of claims 6 to 8, further comprising removing a portion of the magnetic liner located on a top surface of the metal hardmask.

10. The method of any of claims 6 to 9, wherein a thickness of the magnetic liner is 1 nm to 20 nm.

## Patentansprüche

1. Struktur eines magnetischen Direktzugriffsspeichers, MRAM-Struktur, aufweisend:
einen Stapel eines magnetischen Tunnelübergangs (240, 340);
eine magnetische Auskleidung (260, 360), welche zwischen dem Stapel des magnetischen Tunnelübergangs und einem oberen Kontakt (280, 380) angeordnet ist, wobei die magnetische Auskleidung ein ferromagnetisches Material aufweist; und
ein Metall (250, 350), welches zwischen der magnetischen Auskleidung und dem Stapel des magnetischen Tunnelübergangs angeordnet ist;
**dadurch gekennzeichnet, dass** die magnetische Auskleidung nur auf einer aus einer oberen Fläche des Metalls und einer Seitenfläche des Metalls angeordnet ist.

2. MRAM-Struktur nach Anspruch 1, wobei das ferromagnetische Material mindestens ein Material aufweist, ausgewählt aus der Gruppe, bestehend aus: Kobalt, Nickel, Eisen, Seltenerdelementen.

3. MRAM-Struktur nach einem der vorhergehenden Ansprüche, wobei eine Dicke des ferromagnetischen Materials 1 nm bis 20 nm beträgt.

4. MRAM-Struktur nach einem der vorhergehenden Ansprüche, welche ferner eine Diffusionsauskleidung (270, 370) zwischen dem oberen Kontakt und der magnetischen Auskleidung aufweist.

5. MRAM-Struktur nach Anspruch 1, wobei die magnetische Auskleidung auf einer Seitenfläche des Metalls angeordnet ist.

6. Verfahren zum Bilden einer Struktur eines magnetischen Direktzugriffsspeichers, MRAM-Struktur, umfassend:
Bilden eines Stapels eines magnetischen Tunnelübergangs (240, 340);
Bilden einer magnetischen Auskleidung (260, 360) über dem Stapel des magnetischen Tunnelübergangs; und
Bilden eines oberen Kontaktes (280, 380) über der magnetischen Auskleidung, wobei die magnetische Auskleidung ein ferromagnetisches Material aufweist; und
Bilden einer Metall-Hartmaske (250, 350) zwischen der magnetischen Auskleidung und dem Stapel des magnetischen Tunnelübergangs; **dadurch gekennzeichnet, dass** das Verfahren umfasst:
Bilden der magnetischen Auskleidung nur auf einer aus einer oberen Fläche und einer Seitenfläche der Metall-Hartmaske.

7. Verfahren nach Anspruch 6, wobei das ferromagnetische Material mindestens ein Material aufweist, ausgewählt aus der Gruppe, bestehend aus: Kobalt, Nickel, Eisen, Seltenerdelementen.

8. Verfahren nach Anspruch 6, ferner umfassend:
Bilden der magnetischen Auskleidung auf einer Seitenfläche der Metall-Hartmaske.

9. Verfahren nach einem der Ansprüche 6 bis 8, ferner umfassend Entfernen eines Abschnitts der magnetischen Auskleidung, der auf einer oberen Fläche der Metall-Hartmaske angeordnet ist.

10. Verfahren nach einem der Ansprüche 6 bis 9, wobei eine Dicke der magnetischen Auskleidung 1 nm bis 20 nm beträgt.

## Revendications

1. Structure de mémoire vive magnétique, MRAM, comprenant :
un empilement de jonction tunnel magnétique (240, 340) ;
un revêtement magnétique (260, 360) situé entre l'empilement de jonction tunnel magnétique et un contact supérieur (280, 380), dans laquelle le revêtement magnétique comprend un matériau ferromagnétique ; et
un métal (250, 350) situé entre le revêtement magnétique et l'empilement de jonction tunnel magnétique ;
**caractérisée en ce que** le revêtement magnétique est situé uniquement sur une surface parmi une surface supérieure du métal et une surface latérale du métal.

2. Structure MRAM selon la revendication 1, dans laquelle le matériau ferromagnétique comprend au moins un matériau choisi dans le groupe constitué du : cobalt, nickel, fer, d'éléments de terres rares.

3. Structure MRAM selon l'une quelconque des revendications précédentes, dans laquelle une épaisseur du matériau ferromagnétique est de 1 nm à 20 nm.

4. Structure MRAM selon l'une quelconque des revendications précédentes, comprenant en outre un revêtement de diffusion (270, 370) entre le contact supérieur et le revêtement magnétique.

5. Structure MRAM selon la revendication 1, dans laquelle le revêtement magnétique est situé sur une surface latérale du métal.

6. Procédé de formation d'une structure de mémoire vive magnétique, MRAM, comprenant :
la formation d'un empilement de jonction tunnel magnétique (240, 340) ;
la formation d'un revêtement magnétique (260, 360) au-dessus de l'empilement de jonction tunnel magnétique ; et
la formation d'un contact supérieur (280, 380) au-dessus du revêtement magnétique, dans lequel le revêtement magnétique comprend un matériau ferromagnétique ; et
la formation d'un masque dur métallique (250, 350) entre le revêtement magnétique et l'empilement de jonction tunnel magnétique ; **caractérisé en ce que** le procédé comprend :
la formation du revêtement magnétique uniquement sur une surface parmi une surface supérieure et une surface latérale du masque dur métallique.

7. Procédé selon la revendication 6, dans lequel le matériau ferromagnétique comprend au moins un matériau choisi dans le groupe constitué du : cobalt, nickel, fer, d'éléments de terres rares.

8. Procédé selon la revendication 6, comprenant en outre :
la formation du revêtement magnétique sur une surface latérale du masque dur métallique.

9. Procédé selon l'une quelconque des revendications 6 à 8, comprenant en outre le retrait d'une partie du revêtement magnétique située sur une surface supérieure du masque dur métallique.

10. Procédé selon l'une quelconque des revendications 6 à 9, dans lequel une épaisseur du revêtement magnétique est de 1 nm à 20 nm.
